# DEMANDE DE BREVET EUROPEEN

(11) **EP 0 622 808 A1**
(43) Date de publication de la demande: **02.11.1994**
(21) Numéro de dépôt: 94400910.9
(22) Date de dépôt: 27.04.1994
(51) Int. Cl.: G11C 16/06, G11C 11/00, G06F 9/44

(54) **Procédé et dispositif de programmation pour mémoire non volatile électriquement reprogrammable et ensemble comportant un tel dispositif**

(30) Priorité: 29.04.1993 FR 9305089
(71) Demandeur: ALCATEL BUSINESS SYSTEMS, F-75008 Paris (FR)
(72) Inventeur: Kapp, Thierry, F-67400 Illkirch (FR)
(74) Mandataire: Schaub, Bernard

(57) **Abrégé**

Procédé et dispositif de programmation pour mémoire non volatile (1) électriquement reprogrammable associée à un processeur (3) auquel est aussi classiquement associée une mémoire vive(4), l'une et l'autre nécessaires à l'exploitation de ce processeur d'une manière déterminée. Pour charger, en mémoire non volatile (1), les données permanentes nécessaires à l'exploitation du processeur, on aiguille vers une mémoire auxiliaire (7) temporairement reliée, un signal d'activation de mémoire que fournit le processeur afin de démarrer ce processeur à partir de données d'initialisation contenues dans la mémoire auxiliaire, de transférer en mémoire vive les données qui, présentes en mémoire auxiliaire, correspondent aux données à enregistrer dans la mémoire non volatile, avant de les transférer vers cette dernière depuis la mémoire vive, après que le processeur ait désactivé la mémoire auxiliaire.

## Description

L'invention concerne un procédé et un dispositif de programmation pour mémoire(s) non volatile(s) électriquement reprogrammable(s), ainsi qu'un ensemble comportant un tel dispositif.

De manière connue, les mémoires non volatiles électriquement programmables, notamment celles dites de type FLASH EPROM, sont susceptibles d'être programmées, avant d'être montées et soudées sur les cartes de circuit imprimé qu'elles sont destinées à équiper. Toutefois ceci implique des manipulations de ces mémoires avant que ces dernières soient soudées sur les cartes où elles vont être exploitées et l'élimination de ces manipulations supplémentaires est souhaitée.

Il existe aussi des appareils commercialisés permettant de programmer des mémoires non volatiles électriquement reprogrammables lorsque celles-ci sont montées sur des cartes de circuit imprimé qu'elles viennent équiper. Toutefois ces appareils qui se connectent aux cartes pour accéder aux mémoires à programmer, sont relativement coûteux.

L'invention propose donc un procédé de programmation pour mémoire non volatile, électriquement reprogrammable, associée à un processeur auquel est aussi classiquement associée une mémoire vive, l'une et l'autre nécessaires à l'exploitation de ce processeur d'une manière déterminée.

Selon une caractéristique de l'invention, pour charger en mémoire non volatile, vierge ou vide, les données permanentes nécessaires à l'exploitation du processeur de la manière déterminée, on aiguille vers une mémoire auxiliaire temporairement reliée à une liaison bus de communication entre mémoires et processeur, un signal d'activation de mémoire non volatile que fournit le processeur afin de démarrer ce processeur à partir de données d'initialisation contenues dans la mémoire auxiliaire, de transférer en mémoire vive sous le contrôle dudit processeur les données qui, présentes en mémoire auxiliaire, correspondent aux données permanentes destinées à être enregistrées dans la mémoire non volatile, avant de les transférer vers cette dernière depuis la mémoire vive, après que le processeur ait désactivé la mémoire auxiliaire en réaiguillant le signal d'activation vers la mémoire non volatile.

L'invention propose aussi un dispositif de programmation pour mémoire non volatile électriquement reprogrammable associée à un processeur auquel est aussi classiquement associée une mémoire vive, l'une et l'autre nécessaires à l'exploitation de ce processeur d'une manière déterminée et reliées à lui par une liaison bus sur usuellement un même support, notamment de type carte de circuit, à cet effet.

Selon une autre caractéristique de l'invention, ce dispositif comporte une mémoire non volatile, dite auxiliaire, portée par un support indépendant doté de moyens de connexion permettant de relier cette mémoire auxiliaire à la liaison bus à des fins de communication, ainsi qu'un organe d'aiguillage actionnable par le processeur et relié à une sortie de ce processeur pour être apte à aiguiller le signal de sélection de mémoire apparaissant à cette sortie, soit vers la mémoire auxiliaire, soit vers la mémoire non volatile sous l'action du processeur.

L'invention propose encore un ensemble comportant un dispositif de programmation pour au moins une mémoire électriquement reprogrammable associée à un processeur auquel est aussi associée une mémoire vive, l'une et l'autre de ces mémoires, nécessaires à l'exploitation du processeur d'une manière déterminée, étant reliées à lui, usuellement sur un même support, par une liaison bus, à cet effet. Selon une caractéristique de l'invention, l'ensemble comporte des moyens de connexion pour permettre de relier une mémoire auxiliaire externe, à la liaison bus du processeur et un moyen d'aiguillage actionnable par le processeur et relié à une sortie de sélection de mémoire électriquement reprogrammable que comporte ce processeur pour aiguiller le signal de sélection apparaissant à cette sortie, soit vers la mémoire auxiliaire externe, soit vers la mémoire non volatile sous l'action du processeur.

L'invention, ses caractéristiques et ses avantages sont précisés dans la description qui suit en liaison avec la figure unique évoquée ci-dessous.

Cette figure unique présente un schéma d'un dispositif selon l'invention en association avec une carte de circuit imprimé sur laquelle est notamment montée la mémoire non volatile à programmer.

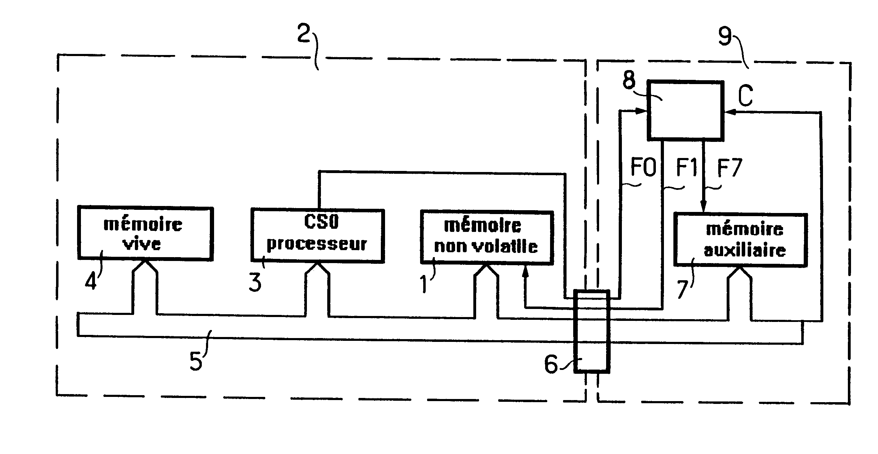

Le dispositif selon l'invention présenté en figure 1 est destiné à permettre la programmation de mémoires non volatiles électriquement reprogrammables et comporte à cet effet des moyens de connexion lui permettant de se mettre en liaison avec une telle mémoire par l'intermédiaire des liaisons de communication desservant cette mémoire sur le support qui la porte.

Dans la forme la plus classique de réalisation, une mémoire non volatile électriquement reprogrammable, telle celle référencée 1, est montée sur une carte de circuit imprimé 2 qui porte aussi un processeur 3, auquel la mémoire 1 est associée, et une mémoire vive 4, également associée au processeur 3.

La mémoire 1 est ici supposée être une mémoire, couramment dite de type FLASH EPROM, qui permet de stocker de manière permanente des données nécessaires au fonctionnement du processeur 3 dans le cadre d'une exploitation au cours de laquelle ce processeur intervient, Elle permet notamment de stocker un programme d'exploitation et en particulier un module de démarrage dans le cadre de ce programme.

La mémoire vive 4 est supposée être apte à assurer un stockage temporaire de données diverses au profit du processeur 3, suivant les besoins en cours d'exploitation, selon une pratique usuelle en la matière.

Les mémoires 1, 4 et le processeur 3 sont reliés à une liaison bus 5 d'échange de données par l'intermédiaire de laquelle ils communiquent entre eux et éventuellement avec au moins un autre élément émetteur et/ou récepteur de données, ce ou ces autres éléments étant susceptibles de se trouver ou non sur la carte 2; dans ce dernier cas cette carte comporte des moyens permettant un accès à la liaison bus 5, classiquement par l'intermédiaire d'un connecteur approprié, ici référencé 6. La liaison bus 5 peut éventuellement être accessible depuis l'extérieur de l'ensemble qui comporte la carte 2 notamment dans le cas où celle-ci fait partie d'un appareil contenu dans un boîtier ou d'un appareillage.

Dans la mesure où la programmation initiale de la mémoire 1 est repoussée après son montage sur la carte 2, il est nécessaire d'effectuer cette programmation avant mise en service de cette carte et selon l'invention on vient temporairement connecter, à la liaison bus 5, une source d'information de programmation telle qu'une mémoire auxiliaire 7 contenant les données qui sont destinées à figurer dans la mémoire 1. Cette mémoire auxiliaire 7, préférablement non volatile, vient par exemple se connecter temporairement à la liaison bus 5 par l'intermédiaire du connecteur 6, de manière à pouvoir communiquer par ce dernier avec les éléments émetteurs et/ou récepteurs de données reliés à cette liaison bus 5, en particulier avec le processeur 3 et avec sa mémoire vive 4 dans le cas présent.

Le processeur 3 comporte des sorties de sélection lui permettant d'activer sélectivement et directement ou indirectement les divers éléments émetteurs et/ou récepteurs qui sont reliés à la liaison bus 5 avec lui, l'une de ces sorties qui est ici référencée CS0 est destinée à être reliée à la mémoire 1 afin de l'activer lorsque cela est nécessaire. Selon l'invention, il est prévu de pouvoir aiguiller le signal de sélection produit par cette sortie de sélection CS0 soit vers la mémoire 1 à laquelle il est normalement destiné, soit vers la mémoire auxiliaire 7, lorsque la mémoire 1 ne contient pas les données que l'on souhaite lui voir contenir, en particulier lorsqu'elle vient d'être installée et qu'elle est vierge de toute donnée.

A cet effet, un organe d'aiguillage 8 est prévu pour mettre en communication la sortie de sélection CS0 du processeur 3 à laquelle il est relié par un fil F0 avec une entrée de sélection correspondante soit de la mémoire 1, via un fil F1, soit de la mémoire 7, via un fil F7, sous le contrôle du processeur 3 auquel il est aussi relié par une entrée de commande C, via la liaison bus 5.

Cet organe d'aiguillage 8 est par exemple prévu sur la carte 2 ou sur le support 9 où se trouve la mémoire auxiliaire 7, comme montré sur la figure. Ce support 9 est par exemple une petite carte venant se raccorder à la carte 2 par l'intermédiaire du connecteur 6 qui assure soit la continuité du fil F7 dans la première hypothèse mentionnée ci-dessus, soit celle des fils F0 et F1 dans la seconde hypothèse telle que présentée sur la figure unique.

Le chargement de données à caractère permanent, dans une mémoire non volatile 1 montée, telles celles définissant un programme d'exploitation, à partir de la mémoire auxiliaire 7 contenant ces données, s'effectue sous la supervision du processeur 3 auquel la mémoire non volatile 1 est associée.

A cet effet, le support 9 et la carte 2 sont interconnectés par l'intermédiaire du connecteur 6, avant que la carte 2 ne soit électriquement alimentée. Dans la mesure où la mémoire non volatile 1 est vierge ou préalablement effacée par voie électrique, le processeur 3 ne peut démarrer de manière habituelle, à partir du module de programme d'exploitation assurant normalement ce démarrage. Par contre un tel module est stocké dans la mémoire auxiliaire 7 pour permettre la mise en marche du processeur 3 et son fonctionnement sur la base d'un programme de chargement particulier. L'organe d'aiguillage 8 est donc préalablement positionné pour que la mémoire auxiliaire 7 soit en communication avec le processeur 3 et que corollairement la mémoire non volatile 1 ne le soit pas.

Suite à la mise en marche, le programme de chargement organise un transfert en mémoire vive 4 des données qui sont contenues dans la mémoire auxiliaire 7 et qui sont à transférer en mémoire non volatile 1 à des fins de stockage permanent au profit du processeur 3. Ce dernier assure ensuite la réactivation de la mémoire non volatile 1 en agissant sur l'organe d'aiguillage 8 et le transfert vers cette mémoire des données qui lui sont destinées et qui sont alors temporairement stockées en mémoire vive 1, ceci s'effectuant par exemple en application d'un module de programme reçu de la mémoire auxiliaire 7 et alors résident en mémoire vive 1.

La réactivation de la mémoire non volatile 1 est accompagnée d'une désactivation de la mémoire auxiliaire 7 qui peut alors être dissociée de la carte 2. Une même mémoire auxiliaire 7 peut bien entendu être successivement associée à différentes cartes 2 ayant les mêmes fonctions, pour assurer le chargement des mémoires non volatiles 1 de ces cartes ou leur éventuel rechargement, tant à la production qu'ultérieurement, en particulier sur site d'exploitation.

## Revendications

**1/** Procédé de programmation pour mémoire non volatile (1), électriquement reprogrammable, associée à un processeur (3) auquel est aussi classiquement associée une mémoire vive(4), l'une et l'autre nécessaires à l'exploitation de ce processeur d'une manière déterminée, caractérisé en ce que pour charger en mémoire non volatile (1), vierge ou vide, les données permanentes nécessaires à l'exploitation du processeur de la manière déterminée, on aiguille vers une mémoire auxiliaire (7) temporairement reliée à une liaison bus de communication (5) entre mémoires et processeur, un signal d'activation de mémoire non volatile que fournit le processeur afin de démarrer ce processeur à partir de données d'initialisation contenues dans la mémoire auxiliaire, de transférer en mémoire vive sous le contrôle dudit processeur les données qui, présentes en mémoire auxiliaire, correspondent aux données permanentes destinées à être enregistrées dans la mémoire non volatile, avant de les transférer vers cette dernière depuis la mémoire vive, après que le processeur ait désactivé la mémoire auxiliaire en réaiguillant le signal d'activation vers la mémoire non volatile.

**2/** Dispositif de programmation pour mémoire non volatile (1), électriquement reprogrammable, associée à un processeur (3) auquel est aussi classiquement associée une mémoire vive (4), l'une et l'autre de ces mémoires nécessaires à l'exploitation de ce processeur d'une manière déterminée et reliées à lui, à cet effet, par une liaison bus (5) sur usuellement un même support (2), caractérisé en ce qu'il comporte une mémoire non volatile, dite auxiliaire, (7) portée par un support indépendant (9) apte à se connecter au support du processeur par l'intermédiaire de moyens de connexion (6) afin de relier cette mémoire auxiliaire à la liaison bus à des fins de communication, ainsi qu'un organe d'aiguillage (8) actionnable par le processeur via la liaison bus et relié à une sortie (CS0) de ce processeur pour aiguiller le signal de sélection de mémoire apparaissant à cette sortie, soit vers la mémoire auxiliaire, soit vers la mémoire non volatile sous l'action du processeur.

**3/** Dispositif de programmation, selon la revendication 2, caractérisé en ce que l'organe d'aiguillage est monté sur le même support indépendant que la mémoire auxiliaire et en ce qu'il est susceptible d'être relié au processeur et à la mémoire non volatile associée à ce processeur par les moyens de connexion prévus pour mettre en communication le support indépendant, sur lequel il est monté, au support des mémoires, vive et non volatile, et du processeur auquel elles sont associées .

**4/** Dispositif de programmation, selon la revendication 2, caractérisé en ce que l'organe d'aiguillage est monté sur le même support que le processeur et que les mémoires, vive et non volatile, associées à ce processeur étant susceptible d'être relié à la mémoire auxiliaire par l'intermédiaire des moyens de connexion prévus pour mettre en communication le support, où il est monté, au support indépendant, où cette mémoire auxiliaire est montée.

**5/** Ensemble comportant au moins une mémoire non volatile (1), électriquement reprogrammable, associée à un processeur (3) auquel est aussi associée une mémoire vive (4), l'une et l'autre de ces mémoires, nécessaires à l'exploitation du processeur d'une manière déterminée, étant reliées à lui, usuellement sur un même support (2), par une liaison bus (5), à cet effet, caractérisé en ce qu'il comporte des moyens de connexion (6) pour permettre de relier une source externe d'informations de programmation (7), notamment de type mémoire auxiliaire externe électriquement reprogrammable, à la liaison bus du processeur et un moyen d'aiguillage (8) actionnable par le processeur et relié à une sortie de sélection (CSO), prévue pour la mémoire électriquement reprogrammable que comporte ce processeur, pour aiguiller le signal de sélection apparaissant à cette sortie, soit vers la source externe d'informations (7), soit vers la mémoire non volatile (1) sous l'action du processeur.
